# EUROPEAN PATENT SPECIFICATION

(11) **EP 4 379 784 B1**
(45) Date of publication and mention of the grant of the patent: **17.09.2025**
(21) Application number: 22210562.9
(22) Date of filing: 30.11.2022
(51) Int. Cl.: H10D 84/01, H01L 21/74, H01L 23/528, H01L 23/535, H01L 21/768, H10D 84/03

(54) **A METHOD FOR FORMING A SEMICONDUCTOR DEVICE WITH A BURIED POWER RAIL**
VERFAHREN ZUR HERSTELLUNG EINER HALBLEITERVORRICHTUNG MIT VERGRABENER STROMSCHIENE
PROCÉDÉ DE FORMATION D'UN DISPOSITIF À SEMI-CONDUCTEUR COMPRENANT UN RAIL D'ALIMENTATION ENTERRÉ

(43) Date of publication of application: 05.06.2024
(73) Proprietor: Imec VZW, 3001 Leuven (BE)
(72) Inventor: CHEN, Rongmei, 3001 Heverlee (BE); VELOSO, Anabela, 3001 Leuven (BE); DE KEERSGIETER, An, 3050 Oud-Heverlee (BE); ENEMAN, Geert, 3001 Heverlee (BE); MATAGNE, Philippe, 4030 Grivegnée (BE)
(74) Representative: AWA Sweden AB

(56) References cited:
- US-A1- 2021 296 156

## Description

### Technical field

The present disclosure relates to a method for forming a semiconductor device.

### Background

Integrated circuits use interconnect structures for providing signal routing and power delivery to active devices (e.g. transistors) formed at the substrate level. An interconnect structure may be formed in the back-end-of-line (BEOL) after the front-end-of-line (FEOL) processing is completed. An interconnect structure comprises a stack of interconnection levels or tiers (e.g. M1, M2, etc.), each including a network of horizontally routed conductive paths (e.g. metal lines) embedded in a layer of interlayer dielectric. Inter-level routing is provided by means of vias extending vertically between the interconnection levels.

Interconnect structures have traditionally been formed on the frontside of the substrate, on top of the active devices. In the strive to provide more area- and power-efficient circuits, and reducing congestion in the frontside interconnect structure, techniques for providing interconnection resources below the level of the active devices have been developed.

One technology is the buried power rail (BPR) wherein the power rails (e.g. VSS and VDD) are "buried" (i.e. embedded) in the substrate. Burying the power rails enables the cross-section of the power rails to be increased (thus reducing IR drop) without occupying valuable space in the frontside interconnect structure, which instead may be used for signal routing. BPRs may be used in conjunction with a backside power delivery network (BS-PDN) for global routing of power to the BPRs using through-silicon vias (TSV), such as nano-TSVs, thereby enabling a further reduction of routing resource usage in the frontside interconnect structure.

While a BS-PDN provides power delivery to the BPRs on the backside, the active-to-BPR connections are traditionally provided on the frontside. The connection may be provided by a so-called Via-to-BPR extending from the device contact level (e.g. a source/drain contact in M0A) and landing on an adjacent BPR. The Via-to-BPR is formed by frontside processing and, at the aggressive device pitches of advanced technology nodes, typically involves high-aspect-ratio etching and metal filling with its associated process challenges. Further, the space required for the Via-to-BPR may hinder continued scaling of device pitches.

The document US 2021/296156 A1 describes fabrication methods and resulting semiconductor structures having a bulb-shaped buried interconnect positioned below a shallow trench isolation region.

### Summary

In light of the above, it is an objective to provide a method facilitating forming of BPRs and mitigating at least some of the issues associated with current frontside approaches for BPR contacting. While the above discussion serves to highlight certain challenges in modern circuit fabrication with reference to BPRs and BS-PDNs, it is envisaged that the methods according to the present invention, set out herein, has a broader applicability. Thus the methods may be used for forming and contacting buried interconnects not dedicated to power delivery, such as buried interconnect lines, buried routing lines, buried inter-cell signal lines for memory or logic applications, or buried contacts. Further and alternative objectives may be understood from the following.

According to an aspect there is provided a method for forming a semiconductor device, comprising:
forming a transistor structure on a frontside of a substrate, the transistor structure comprising a first and a second source/drain body located in a first and a second source/drain region, respectively, and a channel body comprising at least one channel layer extending horizontally between the first and second source/drain bodies;
forming a trench for a buried interconnect beside the first source/drain region, wherein the trench is formed by etching the substrate such that a lower portion of the trench undercuts the first source/drain region;
forming a dielectric liner on interior surfaces of the trench;
forming an opening in the dielectric liner, underneath the first source/drain region; and
subsequent to forming the opening in the dielectric liner, forming a dummy interconnect of a dummy material in the trench;
wherein the method further comprises, subsequent to forming the dummy interconnect:
   exposing the dummy interconnect from a backside of the substrate;
   removing the dummy interconnect selectively to the dielectric liner; and
   forming a buried interconnect of a conductive material in the trench, wherein the buried interconnect is connected to the first source/drain body via the opening in the dielectric liner.

The method allows forming of a buried interconnect underneath a footprint of the transistor structure, more specifically underneath the first source/drain body located in the first source/drain region. The buried interconnect may hence contact the first source/drain body from the backside, instead of a conventional frontside connection by means of a Via-to-BPR. The method accordingly provides a backside contacting approach. The buried interconnect may therefore also be referred to as a "backside interconnect".

As may be appreciated, the steps for forming the transistor structure, the trench, the dielectric liner, the opening and the dummy interconnect are performed from the frontside of the substrate, and accordingly form part of the frontside processing of the substrate. Meanwhile, the subsequent steps of exposing the dummy interconnect, removing the dummy interconnect and forming the buried interconnect are performed from the backside of the substrate and accordingly form part of the backside processing of the substrate. The backside processing may in particular be performed after the frontside processing is completed.

Forming the trench and the dummy wiring line from the frontside facilitates overlay control of the buried interconnect with respect to the transistor structure, in particular with respect to the first source/drain region and the first source/drain body. The opening in the dielectric liner, which also is formed from the frontside, further facilitates controlling the position of the connection between the buried interconnect and the first source/drain body. During backside processing, overlay control with respect to the transistor device (which is formed on the frontside) would otherwise be more challenging.

Furthermore, since the trench, and thus the buried interconnect, is formed to undercut the first source/drain region, less space is needed between adjacent devices to accommodate the buried interconnect. Conversely, the buried interconnect may be formed with a comparably greater width (as seen in a direction transverse to a channel direction of the transistor structure) without increasing a device pitch.

The use of a dummy interconnect (e.g. of a dummy material) and a subsequent replacement of the dummy interconnect by the buried interconnect, additionally provides the benefit enabling the metallization of the interconnect to be postponed, thereby mitigating a risk of metal contamination during the frontside processing.

Spatial terms such as "horizontal" and "vertical", as used herein, are to be understood in relation to the substrate, wherein "horizontal" denotes an orientation or direction parallel to a main plane of extension of the substrate and "vertical" denotes an orientation or direction normal to the main plane of extension of the substrate. Correspondingly, relative spatial terms such as, "upper", "lower", "top", "bottom", "above", "under", "underneath", "below", are to be understood in relation to the substrate, as seen along the vertical/normal direction. The term "lateral" refers to a direction parallel to the substrate, i.e. and thus denotes a horizontal direction.

The terms "frontside" and "backside" of a substrate refer respectively to the two mutually opposite (main) sides of the substrate, wherein the frontside is the side of the substrate on which the transistor (and any further active devices) are formed and the backside is the opposite side of the substrate.

The term "source/drain" as used herein is to be understood as a source or a drain. Hence, "source/drain body" may either be a source body or a drain body. This applies correspondingly to the term "source/drain region". A source/drain region in particular refers to a region along the substrate in which a source/drain body is to be formed or has been formed (depending on the particular stage of the method that the region is referred to).

In some embodiments, forming the trench may comprise etching back the substrate in a direction towards the backside (i.e. a top-down direction as seen along the vertical direction) of the substrate to form an initial trench, and then laterally etching back a sidewall of the initial trench to undercut the first source/drain region. This enables controlling a profile of the trench by first forming the initial trench with an initial depth and then controlling the undercut by the lateral etch back. The etch back of the substrate in a direction towards the backside may be achieved by an anisotropic etch. The lateral etch back of the sidewall of the initial trench may be achieved by an isotropic etch.

The forming of the trench may comprise laterally etching back opposite sidewalls of the initial trench. Hence, a first sidewall of the initial trench and a second sidewall opposite the first sidewall may be laterally etched back simultaneously to form the trench. The first sidewall may be etched back such that the lower portion of the trench undercuts the first source/drain region. The second sidewall may be laterally etched back such that the lower portion of trench further undercuts a source/drain region of a second transistor structure formed at an opposite side with respect to the initial trench.

The forming of the trench may alternatively comprise laterally etching back the sidewall of the initial trench to undercut the first source/drain region while masking an opposite sidewall of the initial trench. This may be useful in case no undercut and buried interconnect is desired underneath an adjacent, neighboring second transistor structure.

In some embodiments, forming the opening in the dielectric liner may comprise: forming a mask layer over the frontside of the substrate and patterning a mask opening in the mask layer, the mask opening exposing a removal portion of the dielectric liner, and subjecting the removal portion of the dielectric liner to an isotropic etch from the mask opening in the mask layer to form the opening in the dielectric liner. Portions of the dielectric liner which are to be preserved may hence be masked by mask layer, while the isotropic etch allows the exposed removal portion of the dielectric liner (i.e. the portion of the dielectric liner which is to be removed to form the opening) underneath the first source/drain region to be selectively accessed and removed.

The mask layer may comprise a mask material filling the trench, wherein the mask opening may be patterned in the mask material by removing the mask material (e.g. selectively) along the removal portion of the dielectric liner. An access opening may be formed in the substrate at a distal side of the first source/drain region and communicating with the lower portion of the trench for the buried interconnect. The mask material may be removed and the opening in the dielectric liner may be formed by etching from the access trench. A distal side of the first source/drain region hereby refers to the side of the first source/drain region distal to the channel body, i.e. the side of the first source/drain region opposite the side facing the channel body. The access opening may for instance be formed by etching the substrate adjacent an end of a fin structure along which the transistor structure is formed.

In some embodiments, the trench for the buried interconnect may be formed to extend beside and undercut the first source/drain region and the channel body, and wherein the opening in the dielectric liner is formed underneath the first source/drain region, i.e. selectively, such that the dielectric liner is preserved underneath the channel body. The trench, and thus the buried interconnect, may accordingly be elongated to extend also underneath the channel body. The buried interconnect may hence be formed in the shape of a line, i.e. a buried interconnect line. The trench may be formed with an even greater length dimension. The trench may be formed to extend beside and undercut also the second source/drain region, wherein the opening in the dielectric liner may be formed selectively underneath the first source/drain region such that the dielectric liner is preserved underneath the channel body and the second source/drain region. The trench and the buried interconnect may accordingly be formed beside and underneath the transistor along its full length. An elongated buried interconnect or line may provide an increased design flexibility for a backside interconnect structure by increasing the area along which the buried interconnect line may be tapped from the backside interconnect structure.

In some embodiments, the transistor structure may be a first transistor structure and the method may further comprise forming (at least) a second transistor structure on the frontside, wherein the second transistor structure comprises a third and a fourth source/drain body located in a third and a fourth source/drain region, respectively, and a second channel body comprising at least one channel layer extending horizontally between the third and fourth source/drain bodies. The trench may be formed to extend beside and undercut the first and the second transistor. The opening in the dielectric liner may be formed selectively underneath the first source/drain region. A second opening may optionally be formed selectively underneath the third source/drain region (such that the dielectric liner is preserved underneath the second channel body and the fourth source/drain region). The buried interconnect (line) may hence be connected also to the third source/drain body via the second opening in the dielectric liner. The first and the second transistor structures may be arranged besides each other, or one after another, e.g. along a same fin structure.

In some embodiments, the transistor structure may further comprises a gate structure extending across the channel body, wherein the gate structure is formed prior to forming the trench for the buried interconnect. Forming the gate structure prior to forming the trench for the buried interconnect may further facilitate overlay control for the position of the contact between the buried interconnect and the first source/drain region.

The source/drain bodies may be formed in the respective source/drain regions, opposite sides of the gate structure, after forming the gate structure and subsequent or prior to forming the trench.

In some embodiments, the method may further comprise cutting the gate structure on a first lateral side of the transistor structure and thereafter forming the trench by etching the substrate on the first lateral side. This may be advantageous, in particular prior to forming an elongated trench on the first lateral side of the transistor structure, extending beside and undercutting the first source/drain region and the channel body. A portion of the gate structure which otherwise would block access to the substrate for etching the trench, may hence be removed during the gate cut formation.

The gate structure may be cut and the trench for the buried interconnect may be formed using a common etch mask. This may improve the overall process efficiency by reducing a number of process steps. That is, the gate structure may be cut and the trench may be formed by etching through a same opening patterned in the common etch mask.

In some embodiments, the method may further comprise, subsequent to removing the dummy interconnect and prior to forming the buried interconnect, forming an opening in a bottom dielectric layer formed underneath the transistor structure to expose a portion of the first source/drain body, wherein the opening in the bottom dielectric layer is formed by etching the bottom dielectric layer from the opening in the dielectric liner. The bottom dielectric layer may physically and electrically separate the transistor structure from the substrate and the buried interconnect, and be selectively opened underneath the first source/drain region to expose the first source/drain body.

In some embodiments, the substrate may comprise a first layer of a first semiconductor material, wherein a base layer is formed on the first layer, and wherein forming the trench may comprise etching the first layer to expose an underside of the base layer, wherein the opening in the dielectric liner may be formed to expose a portion of the underside of the base layer underneath the first source/drain region, and wherein the base layer is the bottom dielectric layer, or
wherein the base layer is of a sacrificial semiconductor material different from the first semiconductor material and the method comprises replacing the base layer with the bottom dielectric layer subsequent to forming the dummy interconnect and prior to exposing the dummy interconnect from a backside of the substrate.

The underside of the base layer hereby refers to the side of the base layer facing away from the frontside of the substrate, i.e. towards the backside.

The base layer may hence be used as a stop layer during the trench formation, thus masking the transistor structure from the etching of the substrate mask from underneath. The base layer may (if formed by the bottom dielectric layer or after being replaced with the bottom dielectric layer) additionally serve to physically and electrically separate the subsequently formed buried interconnect from the active parts of the transistor structure, e.g. the channel body and the source/drain bodies.

The sacrificial semiconductor material may be an epitaxial semiconductor material. A base layer of an epitaxial semiconductor material may facilitate forming the channel layer(s) of the channel body as epitaxial layers of high quality. Selecting the sacrificial semiconductor material to be different from a channel material of the channel layer(s), further allows selective processing of the base layer during the frontside processing, e.g. to replace the base layer with the bottom dielectric layer.

In some embodiments, the substrate comprises a first layer of a first semiconductor material, and a second layer of a material different from the first semiconductor material, wherein the first layer is formed on the second layer, and wherein forming the trench comprises etching the first layer using the second semiconductor layer as a stop layer. This facilitates control of a depth of the trench.

In some embodiments, the aforementioned bottom dielectric layer or base layer may be formed on the first layer wherein a depth of the trench may be precisely controlled by the separation between the second layer and the base layer.

In some embodiments, the substrate may comprise a third layer of a third semiconductor material and wherein the second layer may be formed on the third layer, wherein exposing the dummy interconnect from the backside of the substrate may comprise thinning the third layer from the backside using the second layer as a stop layer, and subsequently opening the second layer to expose the dummy interconnect. The second layer may hence be used as a stop layer both during the trench formation and during the thinning of the substrate. The second layer may be opened in part (e.g. to selectively expose the dummy interconnect), or removed completely from the backside.

In some embodiments, the method may further comprise, subsequent to removing the dummy interconnect, growing, via/through the opening in the dielectric liner, an epitaxial source/drain contact portion on an exposed surface portion of the first source/drain body (i.e. a surface portion of the first source/drain body exposed in the opening in the dielectric liner), and thereafter forming the buried interconnect, i.e. in contact with the source/drain contact portion. A source/drain contact portion may provide an increased contact surface area for the buried interconnect with respect to the first source/drain body, and additionally a combined epitaxial source/drain body (i.e. the source/drain contact portion and the first source/drain body combined) with a greater volume. The greater volume may tune, e.g. increase, an amount of stress induced into the channel body. Tuning the amount of stress allows altering of the electrical properties of the first transistor structure.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figs. 1-12 schematically show a device structure at different stages of a method for forming a semiconductor device, according to various embodiments.
Figs. 13-14 schematically show different layout options for masks which may be used embodiments of the method as depicted in Figs. 1-12.

### Detailed description

Hereafter follows a detailed description of various method embodiments for forming a semiconductor device. More specifically, the methods comprise forming of a buried or backside interconnect contacting a source/drain body of a transistor structure from an underside. Examples of applicable transistor structures include field-effect transistors such as the FinFET device (e.g. comprising a single fin-shaped channel layer) and the horizontal/lateral nanowire- or nanosheet-channel FET device (e.g. comprising a number of vertically stacked nanowires or nanosheets). Specific examples of nanosheet-based devices include the forksheet FET device and the complementary FET (CFET) device. The buried interconnect may be a buried wiring line in the form of a BPR, however that the method is equally applicable to also other types of buried interconnects, such as buried interconnect lines, buried routing lines, buried inter-cell signal lines for memory or logic applications, or buried contacts (e.g. in the shape of vias). In embodiments comprising a BPR, the backside interconnect structure may be configured as a power delivery network. However, the backside interconnect structure may more generally be configured for routing signals for other purposes to the transistor via the buried interconnect, such as some digital signals in logic and memory circuits.

Reference may in the following be made to the "left", "left-hand side", "right" and "right-hand side" in relation to an illustrated device structure, or parts thereof, which references are to be understood within the frame of reference of the figures.

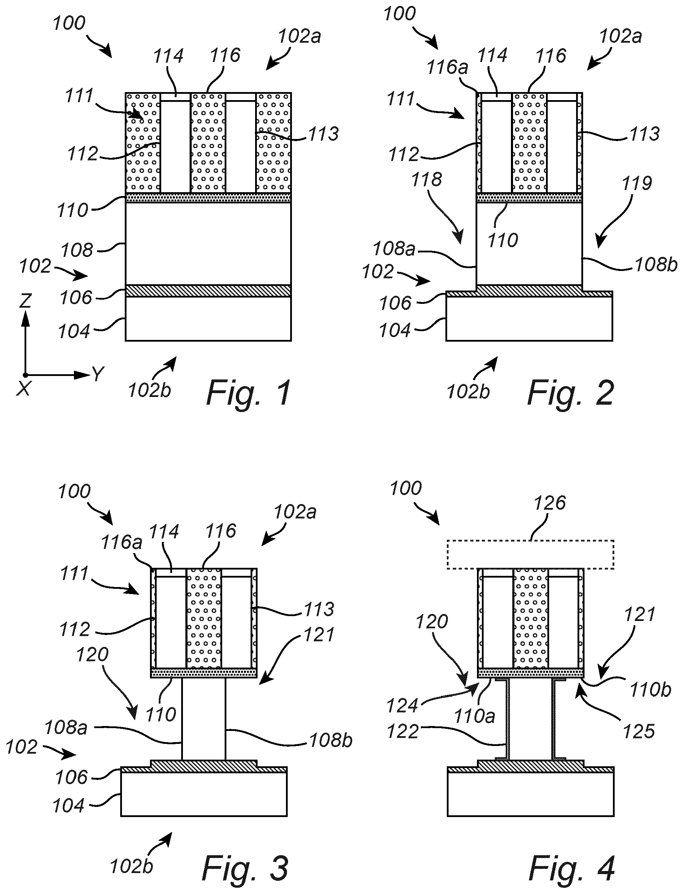

Fig. 1 schematically shows a cross-section of a device structure 100 and a substrate 102 at an initial stage of the method. The cross-section more specifically extends through a first source/drain region in which a first source/drain body of a transistor structure is to be formed. The device structure 100 comprises a substrate 102. The substrate 102 has a first side or frontside 102a and a second side or backside 102b opposite the frontside 102a. A number of semiconductor fins 111, comprising e.g. fins 112 and 113, are formed on the frontside 102a of the substrate 102. As will be further set out below, a number of transistor structures will at a later stage of the method be formed along each fin 111, e.g. by forming gates and source/drain bodies.

The fins 111 may as shown be formed to extend in parallel in a first horizontal direction X along the substrate 102 and be spaced apart in a second horizontal direction Y transverse to the X-direction. The fins 111 protrude above the substrate 102 in a vertical direction Z (with respect to the frontside 102a of the substrate 102). The fins 111 may as shown be single-layered structures, wherein one or more single-channel layer channel bodies may be formed from each such fin 111. Single-layered fins may be formed by patterning an epitaxial layer of a semiconductor material such as Si, Ge, SiGe, or any other semiconductor material (group IV or other) conventionally used for FinFETs. Fin patterning techniques are per se well known in the art and will hence not be further discussed herein. Other compositions of fins 111 are also possible such as multi-layered semiconductor fins comprising a number of vertically stacked channel layers or nanosheets, and formed by patterning a stack of semiconductor layers. A multi-layered semiconductor fin may for instance comprise sacrificial layers of a sacrificial material (e.g. SiGe) and channel layers of a channel material (e.g. Si). Such a fin may be used to form a nanowire- or nanosheet-channel FET device by removing the sacrificial layers selectively to the channel layers using a selective etch prior to gate stack deposition (e.g. to form a gate-all-around). This process is known in the art as the channel nanosheet release or channel nanowire release process (or merely channel release) and the details thereof are per se known in the art and will hence not be further discussed herein. As used herein, the wording "removing" or "etching" a first feature or material "selectively to" a second feature or material means that the first feature or material is removed or etched at a rate greater than the second feature or material, when exposed to the removal or etching process.

With reference again to Fig. 1, each fin 111 may as shown be capped by a hard mask 114 (e.g. remaining from a preceding fin patterning process) and be surrounded by an interlayer dielectric layer 116, of for instance SiO₂ or another insulating material suitable as an interlayer dielectric. Multi-layered compositions of the interlayer dielectric layer 116 are also possible such as a combination of oxide and nitride layers. For conciseness, reference will in the following be made mainly to the fin 112, however the following description applies correspondingly to any further fin 111, such as the fin 113, as will be immediately apparent also from the figures.

The substrate 102 comprises, as seen along a direction from the frontside 102a to the backside 102b, a first layer 108, a second layer 106 and a third layer 104. The first layer 108 is formed on (e.g. directly on) the second layer 106. The second layer is formed on (e.g. directly on) the third layer 104. A base layer 110 is further formed on the frontside 102a of the substrate 102, on (e.g. directly on) the first layer 108.

The first layer 108 is formed of a first semiconductor material. The third layer 104 is formed of a third semiconductor material. The second layer 106 is formed of a material different from each one of the first and third semiconductor materials, such that the second layer 106 may be used as a stop layer during later steps of the method. The second layer 106 may be formed of a second semiconductor material. The third layer 104 may for instance be a bulk Si-layer of the substrate 102. The first through third semiconductor materials may for example each be Si-comprising layers, wherein the Ge-content of the second semiconductor material may be greater than the respective Ge-content of the first and third semiconductor material. As a non-limiting example, a Ge-content of the second semiconductor material may exceed a respective Ge-content of each one of the first and third semiconductor materials by at least 25%. The first and third semiconductor materials may e.g. be Si (e.g. Si₁₋ₓGeₓ with x=0) and the second semiconductor material may be Si_{1-y}Ge_{y} with y≥0.25. Other material combinations are however also possible, such as first and third semiconductor materials of SiGe with a higher Ge-content than a second semiconductor material of Si or SiGe. According to a further option, the second layer 106 may be formed of a non-semiconductor material such as a dielectric (e.g. an oxide and/or nitride). The substrate 102 may for instance be a silicon-on-insulator (SOI) substrate wherein the second layer 106 forms the bonding layer or buried oxide layer between the third layer 104 (e.g. of bulk Si) and the first layer (e.g. of epitaxial Si).

The base layer 110 is like the second layer 106 formed of a material different from the first semiconductor material such that the base layer 110 may be used as a stop layer during later steps of the method. The base layer 110 may for instance be formed of a sacrificial semiconductor material with a composition like or similar to the second semiconductor material (e.g. Si_{1-z}Ge_{z} with z≥0.25). The base layer 110 may however also be formed of a dielectric (e.g. an oxide and/or nitride) wherein the base layer 110 may be provided as a bonding layer between the first layer 108 and the layer(s) of semiconductor material in which the fins 111 subsequently are patterned, as discussed above.

Figs. 2-3 illustrate forming of a trench 120 for a buried interconnect beside the fin 112 at a first lateral side thereof, and extending along (at least) the first source/drain region.

In Fig. 2 an initial trench 118 has been formed by etching back the substrate 102 in a top-down vertical direction (i.e. the negative Z-direction, from the frontside 102a towards the backside 102b). The initial trench 118 may be etched using an anisotropic etching process biased in the top-down direction, e.g. a dry etching process such as reactive ion etching (RIE). The etching may proceed through the base layer 110 (e.g. of a dielectric or a semiconductor such as SiGe) and the first layer 108 (e.g. of Si), and using the second layer (e.g. of a dielectric or SiGe) as an etch stop layer. Depending on the etch contrast between the first semiconductor material and the second (semiconductor) material the forming of the initial trench 118 may as shown result in a slight over-etch into the second layer 106. The etching of the initial trench 118 may thus be stopped on or within the second layer 106.

The initial trench 118 may be formed using a conventional lithography and etching process. A mask layer (not shown) may be formed over the frontside 102a of the substrate 102. The mask layer may be any suitable industry standard lithographic mask layer structure. An opening may be patterned in a resist layer of the mask layer using lithography and subsequently be transferred into the substrate 102 to form the initial trench 118. During the forming of the initial trench 118 the (patterned) mask layer stack may mask the semiconductor fins 112 (e.g. together with the hard mask 114). As shown in Fig.2, the opening in the mask layer stack may be formed such that a thickness portion 116a of the interlayer dielectric layer 116 remains along a sidewall of the fin 112 facing the initial trench 118 facing the first lateral side.

In Fig. 3, a sidewall 108a of the initial trench 118 has been etched back laterally (along the Y-direction) to form the final trench 120 having a lower portion undercutting the first source/drain region and the fin 112 (e.g. as seen along the Z-direction). The lateral etch thus exposes an underside of the base layer 110 (the underside referring to the side of the base layer 110 facing away from the frontside 102a, i.e. towards the backside 102b). The lateral etch back may be achieved by subjecting the first layer 108 to an isotropic etching process from the initial trench 118. The extent or depth of the undercut may be controlled by varying a duration of the isotropic etching process. The lateral etch back may accordingly comprise a timed isotropic etching process. The isotropic etching process may be adapted to etch the first semiconductor material selectively to the respective materials of the base layer 110 and 106, thereby counteracting deepening of the trench 120 as well as exposing the fin 112 from underneath. As a non-limiting example, a SiGe material with a greater amount of Ge than another SiGe material (such as Si) may be etched selectively (i.e. at a greater rate) using an HCl-based dry etch or an ammonia peroxide mixture (APM). Other appropriate etching processes (wet or dry) allowing selective etching of Si-comprising layers with different Ge-content are per se known in the art (e.g. wet or plasma-based processes as used in standard industry processes in connection with channel nanosheet release or cavity etch for inner spacer formation) and may also be employed for this purpose.

During the lateral etch back, the interlayer dielectric layer 116, including the thickness portion 116a, may act as an etch mask, masking the fin 112 from the isotropic etching process from the sides. The mask layer stack may additionally remain to provide masking of the fin 112 from above, together with the hard mask 114. Alternatively, the mask layer stack may be removed prior to the lateral etch back wherein the hard mask 114 alone may mask the fin 112 from above.

The semiconductor fins 111 of the device structure 100 may comprise a further not shown semiconductor fin to the left-hand side of the fin 112, wherein the initial trench 118 may be etched between the further fin and the fin 112. Owing to the isotropic nature of the etching process employed for the lateral etch back in the initial trench 118, both the sidewall 108a and the opposite (not shown) sidewall of the initial trench 118 may be simultaneously etched back laterally in opposite lateral directions (e.g. the positive and the negative Y-direction), wherein the opposite sidewall may be etched back such that the lower portion of the final trench 120 undercuts a source/drain region in which a source/drain body of a further transistor structure is to be formed. This oppositely directed lateral etch back may be seen also in the right-hand portion of Figs. 2-3 in the initial trench 119 formed beside the further fin 113, wherein a lower portion of the final trench 121 undercuts the fin 113 (e.g. a source/drain region in which a source/drain body of a further transistor structure is to be formed). The initial trench 119 (and optionally the final trench 121) may be etched through a second opening patterned in the mask layer stack.

While Figs. 2-3 merely show a cross-section taken at a single position along the fin 112, it is to be understood that the initial trench 118 and the trench 120 may have a longitudinal extension along the X-direction. The initial trench 118 and the trench 120 may for instance further extend along a channel body of the fin 112 (i.e. the portion of the fin 112 along which the channel body of the transistor structure will be defined), and optionally also along a second source/drain region in which a second source/drain body of the transistor structure is to be formed. The trench 120 may accordingly be formed to undercut at least the first source/drain region, and further the channel body and the second source/drain region.

In Fig. 4 a dielectric liner 122 has been formed on interior surfaces (e.g. comprising the sidewalls and bottom surface) of the trench 120. The dielectric liner 122 may be formed by conformally depositing a dielectric liner material, e.g. using atomic layer deposition (ALD). The dielectric liner 122 may be formed of an oxide- or nitride-based material, for instance of SiN, SiC, SiCO, SiCN or SiBCN. In case the base layer 110 is of a dielectric material (thus forming a bottom dielectric layer 110), the dielectric liner material may be of a different material than dielectric material of the base layer 110 and be chosen such that the dielectric liner 122 may be used as an etch mask for opening the base layer 110, as discussed below.

An opening 124 has been formed in the dielectric liner 122, underneath the first source/drain region, wherein the opening 124 exposes a portion 110a of the underside of the base layer 110 underneath the first source/drain region. As may be appreciated from the following, the location of the opening 124 defines the location where the final buried interconnect (formed during backside processing) will contact the transistor structure, i.e. the first source/drain body thereof.

The opening 124 may be patterned in the dielectric liner 122 using a lithography and etching process, wherein a mask layer 126 (indicated by a highly schematic dashed outline) may be formed over the frontside 102a of the substrate 102 and be patterned to define a mask opening in the mask layer 126. The mask layer 126 may be standard lithographic layer stack, for instance a spin-on-carbon/spin-on-glass (SOG/SOC) stack with a resist layer on top, wherein the SOC (or another type of mask material) may be deposited to cover the device structure 100 and fill the trench 120. An initial opening may be patterned in the resist layer and transferred into the SOC using an anisotropic etch (top-down). By a (short) isotropic etch step from the initial opening, SOC may then be laterally etched back to expose, in the lower (undercut) portion of the trench 120, a removal portion of the dielectric liner 122 (i.e. a portion of the dielectric liner 122 to be removed) underneath the first source/drain region. The dielectric liner 122 may thereafter be exposed to an isotropic etch while using the mask layer 126 as an etch mask (i.e. the isotropic etch should selectively etch the dielectric liner material and not appreciably etch the SOC) such that the exposed removal portion of the dielectric liner 122 underneath the first source/drain region may be selectively accessed and removed, while portions of the dielectric liner 122 which are to be preserved may be masked (e.g. underneath the channel body and the second source/drain region, depending on the extension of the trench 120).

In a similar manner, corresponding openings may be formed selectively in the dielectric liner 122 underneath source/drain regions for further transistor structures which are to be formed along the fin 112. As shown, the dielectric liner 122 may also be formed in the trench 121, and a corresponding opening 124 may be formed to expose a portion 110b of the underside of the base layer 110.

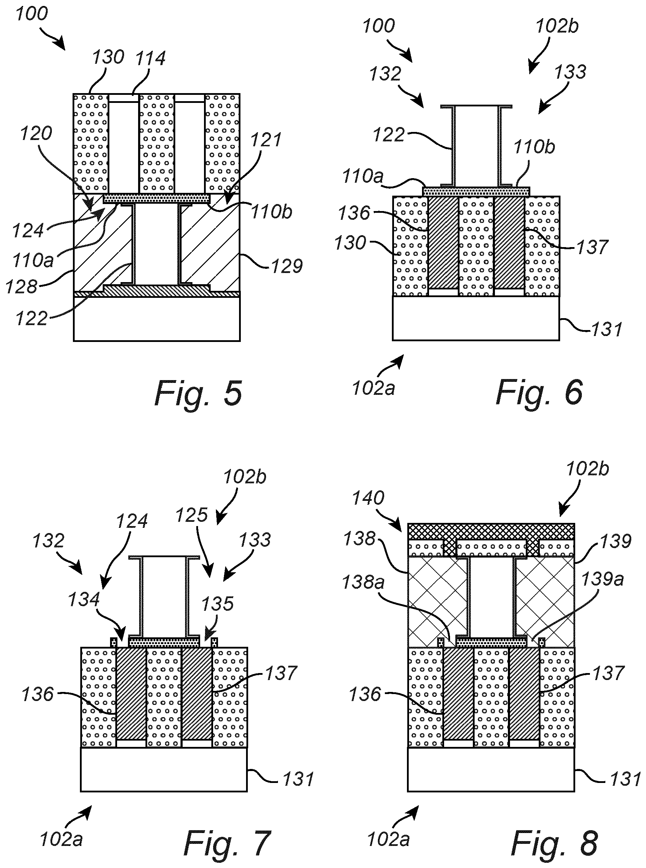

In Fig. 5, a dummy interconnect 128 of a dummy material has been formed in the trench 120. The dummy material may for instance be amorphous silicon or poly-silicon. The dummy material may in general be any material suitable as a sacrificial material, which may be removed selectively to the dielectric liner 122, which may be deposited to reliably fill the trench 120, including the undercut of the lower portion, and which may withstand any remaining high-temperature processing steps of the frontside processing. A corresponding dummy interconnect 129 may be formed in the trench 121, and in any further trench for a buried interconnect. For brevity, reference will in the following mainly be made to the dummy interconnect 128 however the description may apply correspondingly to any further buried interconnect such as 129.

The dummy interconnect 128 may be formed by depositing the dummy material to fill the trench 120 (and any further trench such as the trench 121) and subsequently recessing the dummy material to a thickness or vertical level relative a bottom of the trench 120 such that a vertical dimension (height) of the dummy interconnect 128 corresponds to desired vertical dimension (height) of the buried interconnect which eventually will replace the dummy interconnect 128. The dummy material may for instance be recessed such that an upper surface of dummy interconnect 128 is located at a level slightly above or coinciding with the base layer 110. In any case, due to the lower portion of the trench undercutting the base layer 110, the dummy material may be preserved to cover the portion 110a of the underside of the base layer 110. The recessing may comprise a combination of chemical mechanical polishing (CMP) followed by etch back.

The dummy interconnect 128 may subsequently be covered by an interlayer dielectric layer 130, e.g. a same material or materials as the interlayer dielectric layer 116 as indicated in Fig. 6 by the like fill patterns. The interlayer dielectric material may be deposited and then planarized (e.g. by CMP) to provide the interlayer dielectric layer 130 with a planar upper surface, e.g. flush with the hard mask 114.

Any further remaining steps of the frontside processing may then be performed. The remaining steps of the frontside processing may comprise forming a transistor structure along the fin 112 (e.g. a number of transistor structures each fin 111). Forming the transistor structure may comprise gate patterning to form gates or gate structures (e.g. sacrificial gates) across each channel body portion of each fin 111, gate spacer deposition, performing fin recess in each source/drain region on opposite sides of each gate, performing source/drain epitaxy to form source/drain bodies in the source/drain regions, forming replacement metal gates (RMG), and any further conventional fabrication steps for FinFET of nanowire- or nanosheet-channel FET devices, as needed. For instance, in case transistor structures in the form of nanowire-or nanosheet-channel FET devices are to be formed along the fins 111, the frontside processing may further comprise inner spacer formation, and channel release by removing sacrificial layers of the fins 111, as per se is known in the art. If the base layer is formed of a sacrificial semiconductor material (e.g. SiGe) the semiconductor material of the base layer may additionally be replaced by a dielectric material such that the base layer may form a bottom dielectric layer underneath the transistor structure (or transistor structures along each fin 111). A base layer 110 of a sacrificial semiconductor material may hence be replaced by a base layer 110 of a dielectric material thus forming the bottom dielectric layer. The sacrificial semiconductor material (e.g. SiGe) of the base layer 110 may be removed selectively to the channel material of the channel layer(s) (and a second sacrificial material of the sacrificial layers if present), for instance employing an etch selective to the sacrificial semiconductor material. If sacrificial layers of a second sacrificial material of SiGe are present, a sacrificial semiconductor material of SiGe with a greater Ge-content than the sacrificial material may be used for the base layer 110 to facilitate a selective removal. The replacement process may be performed at various stages of the method, for instance, after fin patterning, prior to sacrificial gate patterning, subsequent to forming the dummy interconnect, after sacrificial gate patterning and prior to source/drain epitaxy, or in connection with channel release, and in any case prior to initiating the backside processing (discussed below). After completing the active device processing, the frontside processing may proceed with contact formation (e.g. M0) followed by forming a frontside interconnect structure (e.g. M1, M2, etc.) using a conventional BEOL process.

Fig. 6 shows the device structure 100 after the frontside processing has been completed. The substrate 102 has been flipped and bonded to a carrier wafer 131, with the frontside 102a facing the carrier wafer 131. Any suitable industry standard bonding technique may be used for this purpose. The substrate 102 has subsequently been thinned from the backside 102b to expose the dummy interconnect 128 (and 129) from the backside 102b. The thinning may more specifically comprise thinning the third layer 104 from the backside, stopping on the second layer 106, and subsequently opening the second layer 106 in a separate etch step to expose the dummy interconnects 128, 129. The second layer 106 may for instance be removed completely.

After exposing the dummy interconnect 128, the dummy interconnect 128 has been removed selectively to the dielectric liner 122, thereby forming a trench 132 exposing the portion 110a of the underside of the base layer 110. The dummy interconnect 128 may be removed using any etching process with a sufficient selectivity to the dummy material.

In Fig. 7, the base layer 110 (which at this stage forms a bottom dielectric layer) has been etched from the opening 124 while using the dielectric liner 122 as an etch mask, thereby forming an opening 134 through the base layer 110, the opening 134 exposing a portion of a first source/drain body 136 (i.e. formed in the first source/drain region during the frontside processing). The base layer 110 may be etched using any etching process with a sufficient selectivity to the dielectric material of the base layer 110. The etching of the base layer 110 may be conducted through a further (not shown) mask layer (e.g. a lithographic layer stack) wherein openings may be patterned in the mask layer to expose the portions of the base layer 110 which are to removed, thereby providing masking of e.g. the dielectric liner 122 and the interlayer dielectric 130. It is to be noted that an opening in the mask layer need not necessarily expose the entire portion 110a of the base layer 110 but may more generally expose at least a sub-portion of the portion 110a of the base layer 110 exposed in the opening 124 in the dielectric liner 122. A dimension of the opening 134 may thus be smaller than a dimension of the opening 124.

The selective exposing of the first source/drain body 136 is allowed by the preceding patterning of the opening 124 in the dielectric liner 122 shown in Fig. 4. Without this preparatory patterning of the dielectric liner 122, it would otherwise be considerably more challenging to control overlay between the opening in the base layer 110 with respect to the first source/drain body 136, as the transistor structure is hidden during the backside processing. Backside processing, as well as related steps such as bonding to a carrier wafer, can additionally induce wafer distortion, which may render overlay control (with respect to the structures on the frontside) even more challenging.

As may be understood, a corresponding opening 135 of the base layer 110 and associated exposure of a source/drain body 137 may be obtained at each location where an opening has previously been patterned in the dielectric liner 122, such as at the opening 125.

In Fig. 8, a buried interconnect 138 of a conductive material has been formed in the trench 132. The buried interconnect comprises a source/drain contact portion 138a extending through the opening in the dielectric liner 122 and the base layer 110 and contacting the first source/drain body 136 located in the first source/drain region. The buried interconnect 138 is hence connected to the first source/drain body 136 of the transistor structure from the backside 102b of the substrate 102, via the opening 124 in the dielectric liner 122. A corresponding source/drain contact portion contacting a respective source/drain body of a respective transistor structure may be formed in each corresponding opening in the dielectric liner 122 and the base layer 110 formed along the trench 132. Additionally, a corresponding buried interconnect 139 comprising a source/drain contact portion 139a contacting the source/drain body 137 may as shown be formed in the further trench 133.

The buried interconnect 138 may be formed by depositing a conductive material, such as one or more metals (e.g. Ru, Mo, W optionally preceded with a metal barrier layer or liner) filling the trench 132. Overburden metal may subsequently be removed by CMP and/or metal etch back.

For an improved isolation between the conductive material of the buried interconnect 138 and semiconductor surfaces exposed in the trench 132, an additional insulating liner layer may be deposited on the interior surfaces of the trench 120 (i.e. prior to forming the dummy interconnect 128) or the trench 132 (i.e. subsequent to removing the dummy interconnect 128 and prior to forming the buried interconnect 138). If the additional insulating liner layer is deposited prior to forming the dummy interconnect 128, the additional insulating liner layer may additionally separate the dummy material of the dummy interconnect 128 from the interior surfaces of the trench 120. The additional insulating liner layer may for instance be formed of an insulating material with an etch contrast with respect to the material of the dielectric liner 122 (e.g. an oxide such as SiO₂). Prior to forming the buried interconnect 138, the additional insulating liner layer may be opened (e.g. by an etch step etching the material of the additional insulating liner layer selectively to the material of the dielectric liner layer 122) to reveal the opening 124 and the portion 110a of the base layer 110 therein. The opening 134 may be formed through the base layer 110 as discussed above. This discussion applies correspondingly to the trench 133 and the buried interconnect 139.

After forming the buried interconnects 138, 139, the method may proceed with forming a backside interconnect structure (where reference sign 140 schematically indicates a first level of a backside interconnect structure) for routing signals or power (depending on the particular application) to the buried interconnect 138 and the source/drain bodes of the transistor structures connected thereto. The backside interconnect structure may be formed using conventional techniques used in the BEOL for forming frontside interconnect structures, such as damascene processing. The specific layout and details of the backside interconnect structure are beyond the scope of the present methods and will hence not be further discussed herein.

Alternatively, the source/drain contact portion 138a of the buried interconnect 138 need not comprise a source/drain contact portion extending through the opening 124 in the dielectric liner 122. Rather, a semiconductor source/drain contact portion may be formed by epitaxially growing a semiconductor material (e.g. in-situ doped) in the opening 134 of the base layer 110, in contact with the exposed portion of the first source/drain body 136. The source/drain contact portion 138a as shown in the figures may according to this variation be considered as a schematic representation of the semiconductor source/drain contact portion instead. The buried interconnect 138 may thereafter be formed by filling the trench 132 with conductive materials (e.g. any of the aforementioned metals). The buried interconnect 138 may thus be connected to the first source/drain body 136 via the semiconductor source/drain contact portion extending through opening 124. The source/drain contact portion may be formed to protrude into the trench 132 such that the buried interconnect 138 may be formed to wrap around an end portion of the source/drain contact portion. The contact surface area towards the buried interconnect 138 may hence be increased. The greater volume of the combined epitaxial source/drain body (formed by the source/drain contact portion and the first source/drain body 136 combined) may further tune the amount of stress induced in the channel body, to thereby tune the electrical performance of the transistor structure. It is envisaged that stress induced in a source/drain body at one side of the transistor structure may propagate throughout the channel body, especially at scaled device dimensions. The source/drain contact portion may be formed of a semiconductor material with a same lattice constant as the semiconductor material of the first source/drain body 136. For example, the source/drain contact portion and the first source/drain body 136 may be formed of a same semiconductor material, such as SiGe with a same Ge-content (SiGe_{0.5} being one non-limiting example). However, it is also possible to form the source/drain contact portion and the first source/drain body 136 of different semiconductor materials with different lattice constants (e.g. SiGe with different Ge-content) which could allow for additional stress modulation. The preceding discussion may apply correspondingly to the source/drain body 137 and the buried interconnect 139.

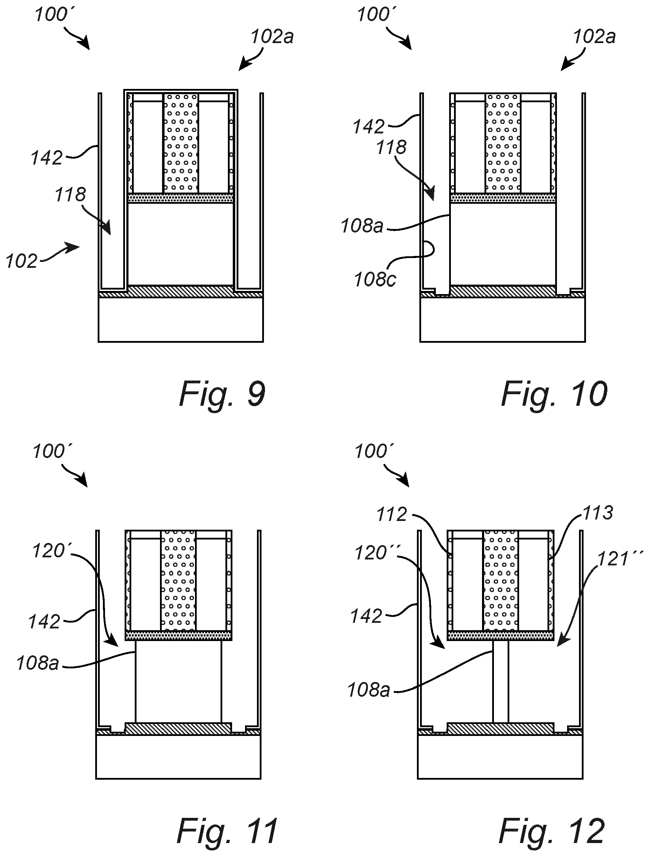

Figs. 9-12 illustrate a variation for forming a trench for a buried interconnect. While the trench 120 (and 121) in the above discussed method was formed by simultaneously laterally etching back opposite sidewalls of the initial trench 118 (and 119), see e.g. Figs. 2-3, the variation shown in Figs. 9-12 achieves a one-sided lateral etch back in the initial trench 118 (and 119).

Fig. 9 shows the device structure 100' after forming the initial trench 118. The device structure 100' shown in Fig. 9 corresponds to the device structure 100 however differs in that after forming the initial trench 118 a mask layer 142, e.g. in the illustrated example formed as a liner, has been formed of the device structure 100'. The mask layer 142 in particular covers the interior surfaces of the initial trench 118.

In Fig. 10 the mask layer 142 has been patterned (e.g. using a lithography and etching process) to define an opening selectively exposing the sidewall 108a of the initial trench 118. The mask layer 142 thus remains along the opposite sidewall 108c of the initial trench 118. The opening may typically be formed to expose the sidewall 108a of the initial trench 118 along its full length.

In Fig. 11, the sidewall 108a of the initial trench 118 has been etched back laterally while masking the opposite sidewall 108c while using the mask layer 142. The sidewall 108c may thus be masked from the isotropic etching process wherein a lateral etch back of the sidewall 108c may be counteracted. At the stage of the lateral etch back shown in Fig. 11, a trench 120' with a lower portion just slightly undercutting the base layer 110 has been formed. As shown in Fig. 12, a duration of the isotropic etching process may be accordingly be extended to achieve a final trench 120" with a deeper undercut with respect to the fin 112. A corresponding trench 121" may be formed to extend beside and to undercut the second fin 113. The method may thereafter proceed in accordance with Fig. 4 and onwards. The mask layer 142 may for instance be formed of any of the material examples mentioned for the dielectric layer 122, such as an ALD layer of a nitride. Portions of the mask layer 142 remaining in the trench 120' may be preserved while portions outside the trench 120' may be removed during the frontside processing steps subsequent to the forming of the trench 120' and the dummy interconnect 128.

In the methods outlined above, steps for forming the trench 120 and the dummy interconnect 128 are performed prior to some frontside active device processing steps, such as gate patterning and source/drain epitaxy. However, these steps may be performed at various stages of the frontside processing. For instance, the trench 120 may and the dummy interconnect may be formed subsequent to sacrificial gate patterning and prior to or subsequent to source/drain epitaxy, or at an even later stage such as after an RMG process. As may be appreciated, in case the trench 120 and the dummy interconnect are formed after the source/drain epitaxy, the lower portion of the trench 120 may be formed to undercut the first source/drain body already formed in the first source/drain region. As discussed above, depending on the longitudinal extension of the trench 120, the lower portion of the trench 120 may additionally undercut a second source/drain body of the transistor structure formed in the second source/drain region. If the trench 120 is to be formed to extend beside also the channel body of the transistor structure, the trench 120 may advantageously be formed after cutting the gate to provide access to the substrate 102 beside the channel body for the etching process. "Cutting the gate" hereby refers to either after cutting the sacrificial gate (a gate-cut-first process) or cutting the metal gate (a gate-cut-last process).

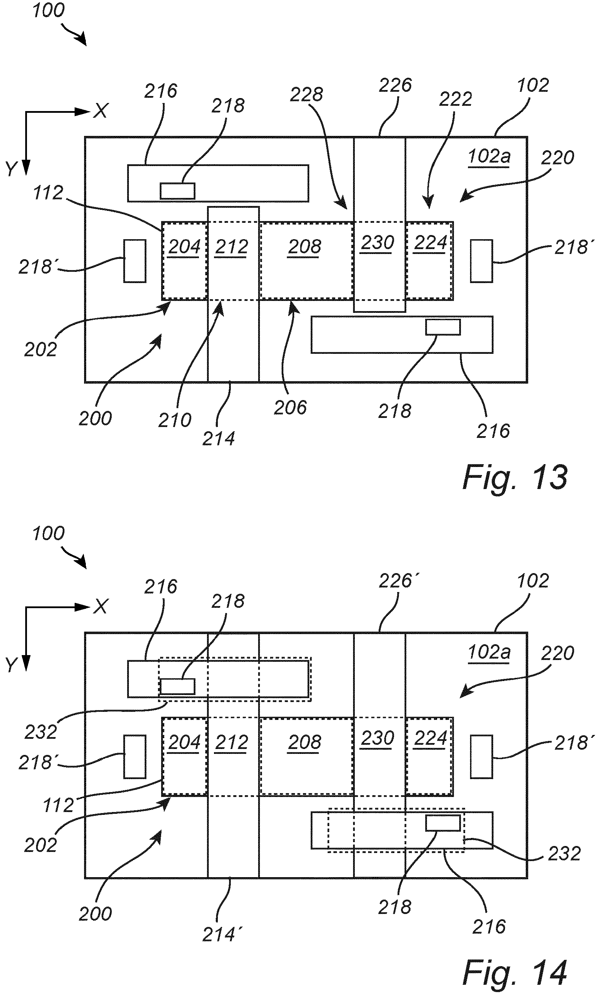

A few mask layout options which may be used for forming the trench 120 and opening the dielectric liner 122 (shown e.g. in Figs. 2-4) will now be discussed with reference to Fig. 13. Fig. 13 is a schematic top-down view from the frontside 102a of the substrate 102 (corresponding to a frontside of the device structure 100).

A transistor structure 200 is formed on the frontside 102a of the substrate 102, along a schematically shown fin 112 (e.g. single-layered or semiconductor fin or a multi-layered fin-shaped structure comprising a stack of channel layers) extending along the X-direction.

The transistor structure 200 comprises a first source/drain body 204 located in a first source/drain region 202, and a second source/drain body 208 located in a second source/drain region 206. The transistor structure 200 comprises a channel body 212 (e.g. comprising one or more channel layers) located in a channel region 210 between the first and second source/drain regions 202, 206 and extending in the X-direction between the first and second source/drain bodies 204, 208. The transistor structure 200 comprises a gate or gate structure 214 extending across the channel body 212. At the stage depicted in Fig. 13, the gate 214 may be a sacrificial gate (to be replaced by a RMG) or a metal gate.

The area designated 216 schematically indicates an example layout for a mask opening 216 in a mask layer which may be used to form the trench 120. With the extension of the mask opening 216 shown in Fig. 13, a trench 120 may be formed to extend beside and undercut the first source/drain region/body 202/204, the channel region/body 210/212 and the second source/drain region/body 206/208. However, this is merely an example and a trench 120 may be formed with a shorter as well as longer extension along the X-direction. The trench 120 may for instance be formed to extend beside and undercut source/drain and channel regions of one or more transistor structures along the fin 112, or only the first source/drain region/body 202/204.

The area designated 218 schematically indicates an example layout for a mask opening 218 in a mask layer (e.g. mask layer 126) which may be used to open the dielectric liner 122. The mask opening 218 may as shown be formed beside and along the first source/drain region 202 such that the opening 124 in the dielectric liner 122 may be formed by removing a portion of the dielectric liner 122 underneath the first source/drain region 202 by an isotropic etch, as discussed above.

The area designated 218' schematically indicates an alternative example layout for a mask opening 218' in a mask layer (e.g. mask layer 126) which may be used to open the dielectric liner 122. According to this alternative example, an opening in the dielectric liner 122 may be formed, instead of by a lateral etch from a lateral side of the transistor structure 200, by a lateral etch from an end of the fin 112, that is from a distal side (distal end) of the first source/drain region 202 opposite the side (end) of the first source/drain region 202 facing the channel region/body 210/212. The end of the fin 112 may be defined during a preceding fin cut process for partitioning an initial longer fin into a number of individual shorter fins. The transistor structure 200 may thus correspond to a transistor structure formed along an end portion of the fin 112. Using a lithography and etching process, the substrate 102 may be etched back in a region adjacent the end of the fin 112 (e.g. the region below region 218') to form an access opening communicating with the lower portion of the trench 120A. The access opening and the trench 120 may for instance be etched simultaneously using a same mask layer. The access opening may like the trench 120 extend to the second layer 106 of the substrate 102 (see e.g. Fig. 3). The opening of the dielectric liner 122 may according to this example proceed by forming a mask layer (e.g. mask layer 126) comprising the mask material (e.g. SOC) filling the trench 120 and the access opening. The mask opening 218' may then be patterned (e.g. by a lithography and etching process) to expose the removal portion of the dielectric liner 122. The patterning may comprise patterning an initial opening in a resist layer and transferring the initial opening through the mask material (e.g. the SOC) and into the access opening using an anisotropic etch (top-down). The removal portion of the dielectric liner 122 underneath the first source/drain region 202 may thereafter be exposed by applying an isotropic etch to the mask material (e.g. selective to the mask material) from the initial opening to cause a lateral etch back of the mask material from the access opening and into the lower portion of the trench 120 along the X-direction. The lateral etch back of the mask material may be a timed etch and stopped when the removal portion of the dielectric liner 122 has been exposed. A further isotropic etch (e.g. selective to the material of the dielectric liner 122) may then be applied to the removal portion of the dielectric liner 122 from the access opening and the opening in mask material to form the opening 124. During the further isotropic etch, portions of the dielectric liner 122 covered by the mask material (i.e. non-removal portions of the dielectric liner 122) may be masked by the mask material such that the opening 124 in the dielectric liner 122 may be formed selectively underneath the first source/drain region 204.

As further shown in Fig. 13, a further transistor structure 220 corresponding to the transistor structure 200 may also be formed along the fin 112. The transistor structure 220 comprises a gate 226 extending across a channel body 230 located in a channel region 228. The second source/drain region 206 and the second source/drain body 208 therein may as shown be shared by the first and second transistor structures 200, 220. The second transistor structure 220 may comprise a further (third) source/drain body 224 in a third source/drain region 222 on an opposite side of the gate 226.

Fig. 14 corresponds to Fig. 13 and in addition to the mask layout options of Fig. 13 shows a layout for a mask opening 232 of a gate cut mask. The gate cut mask may be used to cut the preliminary gates 214', 226' (e.g. which may represent a sacrificial gate or a replacement metal gate) prior to forming the trench 120 by etching the substrate 102 from the mask opening 216. By the gate cut mask, a respective portion of the preliminary gates 214', 216' (which otherwise would block access to the substrate 102 underneath) may be removed prior to forming the trench 120. According to a further option, the gate cut mask and the mask for forming the trench 120 may be combined in a single mask layer. For instance, the gate 214' may be cut and the trench 120 may be etched through a common mask opening, e.g. represented by opening 216.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device, comprising:
forming a transistor structure on a frontside (102a) of a substrate (102), the transistor structure comprising a first and a second source/drain body located in a first and a second source/drain region, respectively, and a channel body comprising at least one channel layer extending horizontally between the first (136) and second source/drain bodies;
forming a trench (120) for a buried interconnect (138) beside the first source/drain region, wherein the trench (120) is formed by etching the substrate (102) such that a lower portion of the trench (120) undercuts the first source/drain region;
forming a dielectric liner (122) on interior surfaces of the trench (120);
forming an opening (124) in the dielectric liner (122), underneath the first source/drain region; and
subsequent to forming the opening (124) in the dielectric liner (122), forming a dummy interconnect (128) of a dummy material in the trench (120);
wherein the method further comprises, subsequent to forming the dummy interconnect (128):
exposing the dummy interconnect (128) from a backside (102b) of the substrate (102);
removing the dummy interconnect (128) selectively to the dielectric liner (122); and
forming a buried interconnect (138) of a conductive material in the trench (120), wherein the buried interconnect (138) is connected to the first source/drain body (136) via the opening (124) in the dielectric liner (122).

2. A method according to any one of the preceding claims, wherein forming the trench (120) comprises etching back the substrate (102) in a direction towards the backside (102b) of the substrate (102) to form an initial trench, and then laterally etching back a sidewall of the initial trench to undercut the first source/drain region.

3. A method according to claim 2, wherein forming the trench (120) further comprises laterally etching back a further sidewall of the initial trench, opposite said sidewall.

4. A method according to claim 2, wherein forming the trench (120) comprises laterally etching back the sidewall of the initial trench to undercut the first source/drain region while masking an opposite sidewall of the initial trench.

5. A method according to any one of the preceding claims, wherein forming the opening (124) in the dielectric liner (122) comprises: forming a mask layer over the frontside (102a) of the substrate (102), patterning a mask opening in the mask layer, the mask opening exposing a removal portion of the dielectric liner (122), and subjecting the removal portion of the dielectric liner (122) to an isotropic etch from the mask opening in the mask layer to form the opening (124) in the dielectric liner (122).

6. A method according to claim 5, wherein the mask layer comprises a mask material filling the trench (120), wherein the mask opening is patterned in the mask material by removing the mask material along the removal portion of the dielectric liner (122), and wherein the mask material is removed by etching from an access opening formed in the substrate (102) at a distal side of the first source/drain region and communicating with the lower portion of the trench (120) for the buried interconnect (138), and wherein the opening (124) in the dielectric liner (122) subsequently is formed by etching from the access opening.

7. A method according to any one of the preceding claims, wherein the trench (120) for the buried interconnect (138) is formed to extend beside and undercut the first source/drain region and the channel body, and wherein the opening (124) in the dielectric liner (122) is formed underneath the first source/drain region such that the dielectric liner (122) is preserved underneath the channel body.

8. A method according to any one of the preceding claims, wherein the transistor structure further comprises a gate structure extending across the channel body, wherein the gate structure is formed prior to forming the trench (120) for the buried interconnect (138).

9. A method according to claim 8, wherein the method further comprises cutting the gate structure on a first lateral side of the transistor structure and thereafter forming the trench (120) by etching the substrate (102) on the first lateral side.

10. A method according to claim 9, wherein the gate structure is cut and the trench (120) for the buried interconnect (138) is formed using a common etch mask.

11. A method according to any one of the preceding claims, further comprising, subsequent to removing the dummy interconnect (128) and prior to forming the buried interconnect (138), forming an opening in a bottom dielectric layer formed underneath the transistor structure to expose a portion of the first source/drain body (136), wherein the opening in the bottom dielectric layer is formed by etching the bottom dielectric layer from the opening (124) in the dielectric liner (122).

12. A method according to claim 11, wherein the substrate (102) comprises a first layer of a first semiconductor material, wherein a base layer is formed on the first layer, and wherein forming the trench (120) comprises etching the first layer to expose an underside of the base layer, wherein the opening (124) in the dielectric liner (122) is formed to expose a portion of the underside of the base layer underneath the first source/drain region, and
wherein the base layer is the bottom dielectric layer, or
wherein the base layer is of a sacrificial semiconductor material different from the first semiconductor material and the method comprises replacing the base layer with the bottom dielectric layer subsequent to forming the dummy interconnect (128) and prior to exposing the dummy interconnect (128) from a backside (102b) of the substrate (102).

13. A method according to any of the preceding claims, wherein the substrate (102) comprises a first layer of a first semiconductor material, and a second layer of a material different from the first semiconductor material, wherein the first layer is formed on the second layer, and wherein forming the trench (120) comprises etching the first layer using the second semiconductor layer as a stop layer.

14. A method according to claim 13, wherein the substrate (102) comprises a third layer of a third semiconductor material and wherein the second layer is formed on the third layer, wherein exposing the dummy interconnect (128) from the backside (102b) of the substrate (102) comprises thinning the third layer from the backside (102b) using the second layer as a stop layer, and subsequently opening the second layer to expose the dummy interconnect (128).

15. A method according to any one of the preceding claims, further comprising, subsequent to removing the dummy interconnect (128), growing, via the opening (124) in the dielectric liner (122), an epitaxial source/drain contact portion on an exposed surface portion of the first source/drain body (136), and thereafter forming the buried interconnect (138).

## Patentansprüche

1. Verfahren zum Bilden einer Halbleitervorrichtung, umfassend:
Bilden einer Transistorstruktur auf einer Vorderseite (102a) eines Substrats (102), wobei die Transistorstruktur einen ersten und einen zweiten Source-/Drain-Körper umfasst, die sich in einer ersten bzw. einer zweiten Source-/Drain-Region befinden, und einen Kanalkörper umfasst, der mindestens eine Kanalschicht umfasst, die sich horizontal zwischen dem ersten (136) und dem zweiten Source-/Drain-Körper erstreckt;
Bilden eines Grabens (120) für eine vergrabene Interconnect-Verbindung (138) neben der ersten Source-/Drain-Region, wobei der Graben (120) durch Ätzen des Substrats (102) so gebildet wird, dass ein unterer Abschnitt des Grabens (120) die erste Source-/Drain-Region unterschneidet;
Bilden einer dielektrischen Auskleidung (122) auf Innenflächen des Grabens (120);
Bilden einer Öffnung (124) in der dielektrischen Auskleidung (122) unterhalb der ersten Source-/Drain-Region; und
im Anschluss an das Bilden der Öffnung (124) in der dielektrischen Auskleidung (122), Bilden einer Dummy-Interconnect-Verbindung (128) aus einem Dummy-Material in dem Graben (120);
wobei das Verfahren im Anschluss an das Bilden der Dummy-Interconnect-Verbindung (128) des Weiteren umfasst:
Freilegen der Dummy-Interconnect-Verbindung (128) von einer Rückseite (102b) des Substrats (102) her;
Entfernen der Dummy-Interconnect-Verbindung (128) selektiv zu der dielektrischen Auskleidung (122); und
Bilden einer vergrabenen Interconnect-Verbindung (138) aus einem leitfähigen Material in dem Graben (120), wobei die vergrabene Interconnect-Verbindung (138) über die Öffnung (124) in der dielektrischen Auskleidung (122) mit dem ersten Source-/Drain-Körper (136) verbunden ist.

2. Verfahren nach einem der vorangehenden Ansprüche, wobei das Bilden des Grabens (120) umfasst, das Substrat (102) in einer Richtung zur Rückseite (102b) des Substrats (102) hin zurückzuätzen, um einen anfänglichen Graben zu bilden, und dann eine Seitenwand des anfänglichen Grabens seitlich so zurückzuätzen, dass die erste Source-/Drain-Region unterschnitten wird.

3. Verfahren nach Anspruch 2, wobei das Bilden des Grabens (120) des Weiteren das seitliche Zurückätzen einer weiteren Seitenwand des anfänglichen Grabens gegenüber der Seitenwand umfasst.

4. Verfahren nach Anspruch 2, wobei das Bilden des Grabens (120) umfasst, die Seitenwand des anfänglichen Grabens seitlich so zurückzuätzen, dass die erste Source-/Drain-Region unterschnitten wird, während eine gegenüberliegende Seitenwand des anfänglichen Grabens maskiert wird.

5. Verfahren nach einem der vorangehenden Ansprüche, wobei das Bilden der Öffnung (124) in der dielektrischen Auskleidung (122) umfasst: Bilden einer Maskenschicht über der Vorderseite (102a) des Substrats (102), Strukturieren einer Maskenöffnung in der Maskenschicht, wobei die Maskenöffnung einen zu entfernenden Abschnitt der dielektrischen Auskleidung (122) freilegt, und Durchführen eines isotropen Ätzens an dem zu entfernenden Abschnitt der dielektrischen Auskleidung (122) von der Maskenöffnung in der Maskenschicht her, um die Öffnung (124) in der dielektrischen Auskleidung (122) zu bilden.

6. Verfahren nach Anspruch 5, wobei die Maskenschicht ein Maskenmaterial umfasst, das den Graben (120) füllt, wobei die Maskenöffnung in dem Maskenmaterial durch Entfernen des Maskenmaterials entlang des zu entfernenden Abschnitts der dielektrischen Auskleidung (122) strukturiert wird, und wobei das Maskenmaterial durch Ätzen von einer Zugangsöffnung her entfernt wird, die in dem Substrat (102) auf einer distalen Seite der ersten Source-/Drain-Region gebildet ist und mit dem unteren Abschnitt des Grabens (120) für die vergrabene Interconnect-Verbindung (138) in Verbindung steht, und wobei die Öffnung (124) in der dielektrischen Auskleidung (122) anschließend durch Ätzen von der Zugangsöffnung her gebildet wird.

7. Verfahren nach einem der vorangehenden Ansprüche, wobei der Graben (120) für die vergrabene Interconnect-Verbindung (138) so gebildet wird, dass er sich neben der ersten Source-/Drain-Region und dem Kanalkörper erstreckt und diese unterschneidet, und wobei die Öffnung (124) in der dielektrischen Auskleidung (122) unterhalb der ersten Source-/Drain-Region so gebildet wird, dass die dielektrische Auskleidung (122) unterhalb des Kanalkörpers erhalten bleibt.

8. Verfahren nach einem der vorangehenden Ansprüche, wobei die Transistorstruktur des Weiteren eine sich über den Kanalkörper erstreckende Gate-Struktur umfasst, wobei die Gate-Struktur vor dem Bilden des Grabens (120) für die vergrabene Interconnect-Verbindung (138) gebildet wird.

9. Verfahren nach Anspruch 8, wobei das Verfahren des Weiteren das Schneiden der Gate-Struktur auf einer ersten lateralen Seite der Transistorstruktur und danach das Bilden des Grabens (120) durch Ätzen des Substrats (102) auf der ersten lateralen Seite umfasst.

10. Verfahren nach Anspruch 9, wobei die Gate-Struktur geschnitten wird und der Graben (120) für die vergrabene Interconnect-Verbindung (138) unter Verwendung einer gemeinsamen Ätzmaske gebildet wird.

11. Verfahren nach einem der vorangehenden Ansprüche, das des Weiteren umfasst, im Anschluss an das Entfernen der Dummy-Interconnect-Verbindung (128) und vor dem Bilden der vergrabenen Interconnect-Verbindung (138) eine Öffnung in einer unteren dielektrischen Schicht zu bilden, die unterhalb der Transistorstruktur gebildet ist, um einen Abschnitt des ersten Source-/Drain-Körpers (136) freizulegen, wobei die Öffnung in der unteren dielektrischen Schicht durch Ätzen der unteren dielektrischen Schicht von der Öffnung (124) in der dielektrischen Auskleidung (122) her gebildet wird.

12. Verfahren nach Anspruch 11, wobei das Substrat (102) eine erste Schicht aus einem ersten Halbleitermaterial umfasst, wobei eine Basisschicht auf der ersten Schicht gebildet wird, und wobei das Bilden des Grabens (120) das Ätzen der ersten Schicht umfasst, um eine Unterseite der Basisschicht freizulegen, wobei die Öffnung (124) in der dielektrischen Auskleidung (122) so gebildet wird, dass ein Abschnitt der Unterseite der Basisschicht unterhalb der ersten Source-/Drain-Region freigelegt wird, und
wobei die Basisschicht die untere dielektrische Schicht ist, oder
wobei die Basisschicht aus einem Opferhalbleitermaterial besteht, das sich von dem ersten Halbleitermaterial unterscheidet, und das Verfahren das Ersetzen der Basisschicht durch die untere dielektrische Schicht im Anschluss an das Bilden der Dummy-Interconnect-Verbindung (128) und vor dem Freilegen der Dummy-Interconnect-Verbindung (128) von einer Rückseite (102b) des Substrats (102) her umfasst.

13. Verfahren nach einem der vorangehenden Ansprüche, wobei das Substrat (102) eine erste Schicht aus einem ersten Halbleitermaterial und eine zweite Schicht aus einem Material, das sich von dem ersten Halbleitermaterial unterscheidet, umfasst, wobei die erste Schicht auf der zweiten Schicht gebildet wird, und wobei das Bilden des Grabens (120) das Ätzen der ersten Schicht unter Verwendung der zweiten Halbleiterschicht als eine Stoppschicht umfasst.

14. Verfahren nach Anspruch 13, wobei das Substrat (102) eine dritte Schicht aus einem dritten Halbleitermaterial umfasst, und wobei die zweite Schicht auf der dritten Schicht gebildet wird, wobei das Freilegen der Dummy-Interconnect-Verbindung (128) von der Rückseite (102b) des Substrats (102) her umfasst, die dritte Schicht von der Rückseite (102b) her unter Verwendung der zweiten Schicht als eine Stoppschicht auszudünnen und anschließend die zweite Schicht zu öffnen, um die Dummy-Interconnect-Verbindung (128) freizulegen.

15. Verfahren nach einem der vorangehenden Ansprüche, das des Weiteren umfasst, im Anschluss an das Entfernen der Dummy-Interconnect-Verbindung (128) über die Öffnung (124) in der dielektrischen Auskleidung (122) einen epitaxialen Source-/Drain-Kontaktabschnitt auf einem freiliegenden Oberflächenabschnitt des ersten Source-/Drain-Körpers (136) zu züchten und danach die vergrabene Interconnect-Verbindung (138) zu bilden.

## Revendications

1. Procédé de fabrication d'un dispositif semi-conducteur, comprenant :
la formation d'une structure de transistor sur une face avant (102a) d'un substrat (102), la structure de transistor comprenant un premier et un deuxième corps de source/drain situés dans respectivement une première et une deuxième région de source/drain et un corps de canal comprenant au moins une couche de canal s'étendant horizontalement entre les premier (136) et deuxième corps de source/drain ;
la formation d'une tranchée (120) pour une interconnexion enterrée (138) à côté de la première région de source/drain, dans lequel la tranchée (120) est formée par gravure du substrat (102) de telle sorte qu'une partie inférieure de la tranchée (120) est en contre-dépouille de la première région de source/drain ;
la formation d'un revêtement diélectrique (122) sur des surfaces intérieures de la tranchée (120) ;
la formation d'une ouverture (124) dans le revêtement diélectrique (122), sous la première région de source/drain ; et
après la formation de l'ouverture (124) dans le revêtement diélectrique (122), la formation d'une interconnexion factice (128) en matériau factice dans la tranchée (120) ;
dans lequel le procédé comprend en outre, après la formation de l'interconnexion factice (128) :
l'exposition de l'interconnexion factice (128) depuis une face arrière (102b) du substrat (102) ;
le retrait de l'interconnexion factice (128) sélectivement du revêtement diélectrique (122) ; et
la formation d'une interconnexion enterrée (138) en matériau conducteur dans la tranchée (120), dans lequel l'interconnexion enterrée (138) est connectée au premier corps de source/drain (136) par l'ouverture (124) dans le revêtement diélectrique (122).

2. Procédé selon une quelconque des revendications précédentes, dans lequel la formation de la tranchée (120) comprend la gravure du substrat (102) en direction de la face arrière (102b) du substrat (102) pour former une tranchée initiale, puis la gravure latérale d'une paroi latérale de la tranchée initiale afin de sous-dépouiller la première région de source/drain.

3. Procédé selon la revendication 2, dans lequel la formation de la tranchée (120) comprend en outre la gravure latérale d'une autre paroi latérale de la tranchée initiale, opposée à ladite paroi latérale.

4. Procédé selon la revendication 2, dans lequel la formation de la tranchée (120) comprend la gravure latérale de la paroi latérale de la tranchée initiale afin de contre-dépouiller la première région de source/drain tout en masquant une paroi latérale opposée de la tranchée initiale.

5. Procédé selon une quelconque des revendications précédentes, dans lequel la formation de l'ouverture (124) dans le revêtement diélectrique (122) comprend : la formation d'une couche de masque sur la face avant (102a) du substrat (102), la formation d'une ouverture de masque dans la couche de masque, l'ouverture de masque exposant une partie de retrait du revêtement diélectrique (122), et la soumission de la partie de retrait du revêtement diélectrique (122) à une gravure isotrope à partir de l'ouverture de masque dans la couche de masque pour former l'ouverture (124) dans le revêtement diélectrique (122).

6. Procédé selon la revendication 5, dans lequel la couche de masque comprend un matériau de masque remplissant la tranchée (120), dans lequel l'ouverture de masque est formée dans le matériau de masque par retrait du matériau le long de la partie de retrait du revêtement diélectrique (122) et dans lequel le matériau de masque est retiré par gravure à partir d'une ouverture d'accès formée dans le substrat (102) sur un côté distal de la première région de source/drain et communiquant avec la partie inférieure de la tranchée (120) pour l'interconnexion enterrée (138) et dans lequel l'ouverture (124) du revêtement diélectrique (122) est ensuite formée par gravure à partir de l'ouverture d'accès.

7. Procédé selon une quelconque des revendications précédentes, dans lequel la tranchée (120) destinée à l'interconnexion enterrée (138) est formée de manière à s'étendre à côté et en contre-dépouille de la première région de source/drain et du corps du canal, et dans lequel l'ouverture (124) dans le revêtement diélectrique (122) est formée en dessous la première région de source/drain de sorte que le revêtement diélectrique (122) soit préservé sous le corps du canal.

8. Procédé selon une quelconque des revendications précédentes, dans lequel la structure du transistor comprend en outre une structure de grille s'étendant à travers le corps de canal, dans lequel la structure de grille est formée avant la formation de la tranchée (120) destinée à l'interconnexion enterrée (138).

9. Procédé selon la revendication 8, dans lequel le procédé comprend en outre la découpe de la structure de grille sur un premier côté latéral de la structure de transistor, puis la formation de la tranchée (120) par gravure du substrat (102) sur le premier côté latéral.

10. Procédé selon la revendication 9, dans lequel la structure de grille est découpée et la tranchée (120) pour l'interconnexion enterrée (138) est formée en utilisant un masque de gravure commun.

11. Procédé selon une quelconque des revendications précédentes, comprenant en outre, après le retrait de l'interconnexion factice (128) et avant la formation de l'interconnexion enterrée (138), la formation d'une ouverture dans une couche diélectrique inférieure formée sous la structure de transistor afin d'exposer une partie du premier corps de source/drain (136), dans lequel l'ouverture dans la couche diélectrique inférieure est formée par gravure de la couche diélectrique inférieure à partir de l'ouverture (124) dans le revêtement diélectrique (122).

12. Procédé selon la revendication 11, dans lequel le substrat (102) comprend une première couche d'un premier matériau semi-conducteur, dans lequel une couche de base est formée sur la première couche et dans lequel la formation de la tranchée (120) comprend la gravure de la première couche pour exposer une face inférieure de la couche de base, dans lequel l'ouverture (124) dans le revêtement diélectrique (122) est formé afin d'exposer une partie de la face inférieure de la couche de base en dessous de la première région de source/drain et dans lequel la couche de base est la couche diélectrique inférieure ou
dans lequel la couche de base est constituée d'un matériau semi-conducteur sacrificiel différent du premier matériau semi-conducteur, et le procédé comprend le remplacement de la couche de base par la couche diélectrique inférieure après la formation de l'interconnexion factice (128) et avant l'exposition de cette dernière depuis la face arrière (102b) du substrat (102).

13. Procédé selon une quelconque des revendications précédentes, dans lequel le substrat (102) comprend une première couche d'un premier matériau semi-conducteur et une deuxième couche d'un matériau différent du premier matériau semi-conducteur, dans lequel la première couche est formée sur la deuxième couche et dans lequel la formation de la tranchée (120) comprend la gravure de la première couche en utilisant la deuxième couche semi-conductrice comme couche d'arrêt.

14. Procédé selon la revendication 13, dans lequel le substrat (102) comprend une troisième couche d'un troisième matériau semi-conducteur et dans lequel la deuxième couche est formée sur la troisième couche, dans lequel l'exposition de l'interconnexion factice (128) depuis la face arrière (102b) du substrat (102) comprend l'amincissement de la troisième couche depuis la face arrière (102b) en utilisant la deuxième couche comme couche d'arrêt, puis l'ouverture de la deuxième couche pour exposer l'interconnexion factice (128).

15. Procédé selon une quelconque des revendications précédentes, comprenant en outre, après le retrait de l'interconnexion factice (128), la croissance, via l'ouverture (124) du revêtement diélectrique (122), d'une partie de contact source/drain épitaxiale sur une partie de surface exposée du premier corps de source/drain (136), puis la formation de l'interconnexion enterrée (138).
